# EUROPEAN PATENT APPLICATION

(11) **EP 2 765 616 A1**
(43) Date of publication of application: **13.08.2014**
(21) Application number: 12837703.3
(22) Date of filing: 21.09.2012
(51) Int. Cl.: H01L 31/042, B32B 27/30, B32B 27/32, B32B 27/36

(54) **BACK-PROTECTIVE SHEET FOR SOLAR CELL MODULE AND SOLAR CELL MODULE USING SAME**

(30) Priority: 05.10.2011 JP 2011220663
(71) Applicant: Toray Advanced Film Co., Ltd., Chuo-ku Tokyo 103-0021 (JP)
(72) Inventor: OKUYAMA Futoshi, Mishima-shi, Shizuoka 411-0824 (JP); KATOU, Kouhei, Mishima-shi, Shizuoka 411-0824 (JP); TANIGUCHI Kouji, Takatsuki-shi, Osaka 569-0807 (JP); HAN, Suion, Mishima-shi, Shizuoka 411-0824 (JP); TERANISHI, Masayoshi, Mishima-shi, Shizuoka 411-0824 (JP)
(74) Representative: Kador & Partner
(86) International application number: PCT/JP2012/074199
(87) International publication number: WO 2013/051403

(57) **Abstract**

A back-protective sheet for a solar cell module, characterized in that: the sheet comprises a polyolefin-based resin three-layered film composed of layers (A), (B) and (C), a plastic film and an ultraviolet absorbing layer which are laminated in this order; said layer (A) comprises a resin composition obtained by mixing a polyethylene-based resin with a polypropylene-based resin; the layer (B) comprises a polypropylene-based resin composition that contains white fine particles; and the layer (C) comprises a polypropylene-based resin composition. The back-protective sheet has excellent heat resistance and hiding power, so that when thermocompression-bonded in a lamination step, the film is not so thinned by an influence of an edge of a photovoltaic device or a wiring member as to make the photovoltaic device or the wiring member visible through the sheet. Further, the back-protective sheet exhibits excellent voltage endurance characteristics by virtue of little deformation in processing, and is little deteriorated by an influence of ultraviolet light.

## Description

### Technical Field

This invention relates to a back-protective sheet for a solar cell module and a solar cell module prepared by using such sheet. More specifically, this invention relates to a back-protective sheet for a solar cell module having an excellent heat resistance so that it will not experience thermal deformation resulting in defects in the production of the solar cell module and it will be provided with an excellent weatherability, as well as the solar cell module prepared by using such sheet.

### Background Art

With the rise of consciousness for the environmental issues, solar cells have become a focus of attention as a cleaner energy source, and various forms of solar cell modules have been developed and proposed. A solar cell module is typically produced by using an photovoltaic cell such as crystalline silicon photovoltaic cell or amorphous silicon photovoltaic cell, and laminating a front protective sheet, an encapsulat sheet of an ethylene - vinyl acetate copolymer resin, a photovoltaic cell, a encapsulat sheet, and a back-protective sheet layer in this order and integrating the sheets by vacuum suction followed by thermal pressing. For the back-protective sheet constituting the solar cell module, a plastic substrate which is lightweight and excellent in electric properties and strength have been commonplace, and in view of the light weight, moisture prevention, and high voltage resistance property, a polyolefin resin film is increasingly used. Since problems inherent to the polyolefin resin film should be solved before using the polyolefin resin film for the member of a back-protective sheet for a solar cell module, various proposals have been introduced. For example, Patent Document 1 discloses a back-protective sheet for a solar cell module comprising a laminate of particular polyolefin resin multi-layer film and biaxially oriented polyethylene terephthalate film.

The back-protective sheet for a solar cell module prepared by using a polyolefin resin film is required to have mutually contradictory properties, namely, thermal adhesion property of the ethylene - vinyl acetate copolymer (hereinafter abbreviated as EVA) sheet used as the adhesive resin layer of the solar cell module and the heat resistance for suppressing the deformation by heat and pressure in the pressing into the module. Patent Document 2 discloses a method using a film prepared by adding a UV blocker and an antioxidant to a polyethylene resin having a density of 0.940 to 0.970 g/cm³. This formulation, however, has insufficient heat resistance despite its excellent thermal adhesion with the EVA sheet, and problems such as visibility of the power generation element and the wiring through the partially thinned sheet and poor voltage resistance property are associated due to the partial thinning of the film by the film deformation as a result of the heat and pressure in the production process of the solar cell module.

Patent Document 3 describes a back-protective sheet for a solar cell module comprising a laminate of a polypropylene resin and a polyethylene resin prepared for the purpose of improving the resistance against penetration of the solar cell electrode by the solder projection. However the laminate prepared by merely laminating a polypropylene resin and a polyethylene resin by co-extrusion is readily peeled at the interface of the lamination, and the use of such sheet for the back-protective sheet for a solar cell module has many limitations.

In the back-protective sheet for a solar cell module prepared by using a polyolefin resin film, it is also important to prevent deterioration such as yellowing, loss of the strength, and generation of cracks of the back-protective sheet by the influence of the UV ray from the back surface.

### Prior Art Documents

### Patent documents

Patent Document 1: Japanese Patent Application Laid-Open No. 2011-51124
Patent Document 2: Japanese Patent Application Laid-Open No. 1999-261085
Patent Document 3: Japanese Patent Application Laid-Open No. 2004-223925

### Summary of the Invention

### Problems to Be Solved by the Invention

An object of the present invention is to provide a back-protective sheet for a solar cell module prepared by using a polyolefin resin film which has a heat resistance and covering property sufficient for avoiding the photovoltaic cell and the wiring members becoming visible by the thinning of the back-protective sheet for the solar cell module as a result of the influence by the terminal of the photovoltaic cell and the wiring members such as electrode (interconnector) for mutually connecting the adjacent photovoltaic cells and collecting electrode called bus bar for mutually connecting the cell strings in the thermal pressing in the lamination step of the production process of the solar cell module; and which also exhibits reduced degradation such as yellowing as a result of the influence by UV ray. Another object of the present invention is to provide a solar cell module provided by using the back-protective sheet for a solar cell module.

### Means for Solving the Problems

In order to solve the problems as described above, the present invention provides a back-protective sheet for a solar cell module comprising a polyolefin resin multi-layer film having a layer A / layer B / layer C three layer constitution, a plastic film, and a UV absorbing layer disposed in this order; wherein the layer A comprises a resin composition prepared by mixing a polyethylene resin and a polypropylene resin, the layer B comprises a polypropylene resin composition containing white particles, and the layer C comprises a polypropylene resin composition.

### Merits of the Invention

The back-protective sheet for a solar cell module of the present invention has a heat resistance and covering property sufficient for avoiding the photovoltaic cell, interconnector, or bus bar becoming visible by the thinning of the back-protective sheet for the solar cell module as a result of the influence by the terminal of the photovoltaic cell and the wiring members such as interconnector for mutually connecting the adjacent photovoltaic cells and collecting electrode called bus bar for mutually connecting the cell strings in the thermal pressing in the lamination step of the production process of the solar cell module. The back-protective sheet for a solar cell module of the present invention also exhibits reduced degradation such as yellowing as a result of the influence by UV ray. Also provided is a solar cell module provided by using such back-protective sheet for a solar cell module. The back-protective sheet for a solar cell module of the present invention also exhibits excellent thermal adhesion with the adhesive resin such as EVA used as the sealant of the solar cell module, and also, excellent adhesion between the interior sheet layers.

### Brief Description of the Drawings

[FIG. 1] FIG. 1 is a schematic cross-sectional view showing an embodiment of the back-protective sheet for a solar cell module of the present invention.
[FIG. 2] FIG. 2 is a schematic cross-sectional view showing an embodiment of the solar cell module of the present invention.
[FIG. 3] FIG. 3 is a schematic cross-sectional view showing the method used for testing the heat resistance of the back-protective sheet for a solar cell module of the present invention.
[FIG. 4] FIG. 4 is a schematic cross-sectional view showing the method used for measuring the adhesion strength of the back-protective sheet for a solar cell module of the present invention with EVA.

### Embodiments for Carrying Out the Invention

Next, the present invention is described in further detail by referring to preferred embodiments.

The back-protective sheet for a solar cell module of the present invention is a back-protective sheet for a solar cell module comprising a laminate of a polyolefin resin multi-layer film having a layer A / layer B / layer C three layer constitution, a plastic film, and an UV absorbing layer disposed in this order

The plastic film used in the present invention may be a monolayer film or a multi-layer film prepared by adhering two or more films.

Examples of the plastic film used in the present invention include films of a polyester such as polyethylene terephthalate (hereinafter abbreviated as PET) or polyethylene naphthalate (hereinafter abbreviated as PEN), films of a polyolefin such as polyethylene or polypropylene, polystyrene film, polyamide film, polyvinyl chloride film, polycarbonate film, polyacrylonitrile film, polyimide film, and fluororesin film. Among these, the preferred is a polyethylene terephthalate film in view of the mechanical strength, heat resistance, and cost effectiveness, and in further view of the long term retention of the properties, and the more preferred are hydrolysis resistant polyethylene terephthalate films (hereinafter abbreviated as hydrolysis resistant PET films). Similarly, the preferred is a PEN film in view of realizing the high hydrolysis resistance.

Use of a fluororesin film for the plastic film of the present invention is also preferable in view of the weatherability, and also preferred is the use of a laminate film of a polyester film with the fluororesin film.

In the present invention, the hydrolysis resistant PET film preferable for use as the plastic film is the one which retains at least 60% of the initial tensile elongation after storing in the high pressure steam of 140°C for 10 hours.

When a hydrolysis resistant PET film capable of retaining at least 60% of the initial tensile elongation after storing 10 hours in a high pressure steam at 140°C is used for the plastic film constituting the back-protective sheet for a solar cell module, the back-protective sheet for a solar cell module will have a greatly improved weatherability, and use of such plastic film contributes for the retention of the performance of the solar cell module for 10 or more years. Accordingly, use of such plastic film is preferable.

The hydrolysis resistant PET film well adapted for use as the plastic film of the present invention can be obtained by biaxially stretching a PET having an intrinsic viscosity [η] of 0.70 to 1.20, and more preferably 0.75 to 1.00, wherein the dicarboxylic acid component comprises terephthalic acid and the diol component comprises ethyleneglycol. The intrinsic viscosity [η] as used herein is the value determined by dissolving the PET by using o-chlorophenol for the solvent and conducting the measurement at a temperature of 25°C, and this viscosity is proportional to the degree of polymerization of the PET. Increase in the degree of polymerization of the PET is important for the improvement of the hydrolysis resistance, and exemplary methods for increasing the degree of polymerization include a method wherein the polymerization is allowed to proceed under reduced pressure in a long polymerization time while removing the ethylene glycol, and a so called "solid phase polymerization" method wherein the PET resin which has be polymerized by the method as described above is further subjected to crystallization treatment, and then to a heat treatment at a high temperature under reduced pressure to thereby further increase the degree of polymerization. The intended value of the intrinsic viscosity [η] can be realized by these methods. When the intrinsic viscosity is at least 0.70, hydrolysis resistance and heat resistance can be readily imparted, and the resulting back-protective sheet, and hence, the solar cell module will have an improved resistance to the hydrolysis, and the intrinsic viscosity value is preferably in such range. The intrinsic viscosity is preferably up to 1.20, since the melt viscosity will be low and the melt extrusion will be easy, and film formation is thereby facilitated.

These PET resins may be either a homo PET resin or the one containing a copolymerization component. Exemplary copolymerization components include diol components such as diethylene glycol, neopentyl glycol, and polyalkylene glycol, and dicarboxylic acid components such as adipic acid, sebacic acid, phthalic acid, isophthalic acid, 2,6-naphthalene dicarboxylic acid, and 5-sodium sulfoisophthalic acid. If desired, the PET resin may optionally contain adequate additives such as heat stabilizer, oxidation stabilizer, UV absorbent, weathering stabilizer, organic slip agent, organic fine particles, encapsulat, antistatic agent, nucleic agent, dye, dispersant, and coupling agent at a content not adversely affecting the effects of the present invention.

The biaxially stretched film is produced from the PET resin by optionally drying the PET resin, supplying the PET resin to a melt extruder known in the art, extruding the sheet from a slit die, and bringing the sheet in close contact with a metal drum to cool the sheet to a temperature not exceeding the glass transition temperature of the PET resin and obtain the unstretched film. The unstretched film is then biaxially stretched by a known method such as simultaneous biaxial stretching or sequential biaxial stretching to obtain the biaxially stretched film. With regard to the conditions used in this process, the film may be stretched at an arbitrarily temperature of at least the glass transition temperature Tg of the PET resin and up to Tg + 100°C, and the temperature of the stretching is typically in the range of 80 to 170°C in view of the final physical properties and productivity of the finally obtained film. The ratio of stretching may be selected from the range of 1.6 to 5.0, and preferably 1.7 to 4.5 for both the machine and the transverse directions of the film. The speed of stretching is preferably 1000 to 200000%/minute. The film is heat treated after the stretching, and this heat treatment may be continuously conducted in a heat treatment chamber provided after the tenter for stretching the film in the transverse direction, or alternatively, by heating the stretched film in a separately provided oven or heating roll. The heat treatment is typically conducted at a temperature in the range of 120 to 245°C for a period of 1 to 60 seconds, and in the heat treatment, a reluxation treatment may be conducted for the purpose of improving dimensional stability under heating in transverse and machine directions.

PET films capable of retaining at least 60% of the initial tensile elongation after storing 10 hours in a high pressure steam at 140°C are commercially available including the PET films which exhibit 50% reduction time of the elongation at break measured in a high pressure steam at 140°C compared to the elongation at break before the steam treatment that is twice or more compared to the films not having the hydrolysis resistance when the elongation at break of the film is measured according to JIS C2151 (1996). Examples of such films include "Lumilar (Registered Trademark)" X10S manufactured by Toray Industries, Inc. and the like, and they are preferable for use as the plastic film of the present invention.

The PEN film which is preferable for use as the plastic film of the present invention is the film prepared by using the resin prepared by polymerizing the resin using 2,6-naphthalene dicarboxylic acid for the dicarboxylic acid component and ethylene glycol for the diol component by a known method, and biaxially stretching the film in a method known in the art as described above.

The hydrolysis resistant PET film or the PEN film may preferably have a thickness of 38 to 300 µm, and in view of the stiffness and voltage resistance of the film, cost of the back-protective sheet for a solar cell module, and the workability in the production of the solar cell module, the thickness is more preferably 50 to 250 µm.

In addition, the hydrolysis resistant PET or the PEN film may preferably have a thickness of 200 to 250 µm to pass the HAI (high-current arc ignition) test in the flame retardancy specification UL 746A.

The fluororesin film which is preferable for the plastic film of the present invention may be prepared by melting the fluororesin, extruding the resin in sheet form from the nozzle, and cooling and solidifying the sheet on a rotary cooling drum to obtain the fluororesin film having the intended thickness.

Exemplary fluororesins include polyvinyl fluoride, polyvinylidene fluoride, tetrafluoroethylene - hexafluoropropylene - vinylidene fluoride copolymer, tetrafluoroethylene - propylene copolymer, tetrafluoroethylene - hexafluoropropylene - propylene copolymer, ethylene - tetrafluoroethylene copolymer (ETFE), hexafluoropropylene - tetrafluoroethylene copolymer (FEP), or perfluoro(alkylvinyl ether) - tetrafluoroethylene copolymer, and polychlorotrifluoroethylene resin. Of these fluororesins, the most preferred are polyvinyl fluoride, ethylene - tetrafluoroethylene copolymer (ETFE), hexafluoropropylene - tetrafluoroethylene copolymer (FEP), perfluoro (alkylvinyl ether) - tetrafluoroethylene copolymer, and polychlorotrifluoroethylene polymer in view of the melt extrusion moldability in the film production.

The fluororesin film of the present invention can be subjected to a surface activation treatment such as corona discharge treatment, plasma treatment, flame treatment, or chemical treatment to improve the adhesion strength after the lamination.

Another preferable plastic film of the present invention is a film prepared by laminating the polyester film and the fluororesin film as described above.

The polyolefin resin multi-layer film of the present invention has a layer A / layer B / layer C three layer constitution, and the layer A comprises a resin composition prepared by mixing a polyethylene resin with a polypropylene resin. Exemplary polyethylene resins used for the layer A include a low density polyethylene, linear low density polyethylene, high density polyethylene, and mixtures thereof.

The linear low density polyethylene is a copolymer of ethylene with an α-olefin (hereinafter abbreviated as LLDPE), and the LLDPE is preferably a copolymer of ethylene with an α-olefin containing 4 to 20 carbon atoms, and more preferably 4 to 8 carbon atoms such as butene-1, pentene-1, 4-methyl-1-pentene, hexene-1, heptene-1, octene-1, nonene-1, or decene-1, which may be used alone or in combination. The α-olefin is more preferably butene -1, hexene-1, octene-1, or the like in view of the productivity of the polymerization.

The LLDPE of the layer A in the present invention may preferably have a melting point in the range of 110 to 130°C. When the melting point up to 130°C, the LLDPE will exhibit good thermal adhesion with the EVA, and the melting point of at least 110°C is preferable since the sheet will then retain its thickness in the thermal pressing with the EVA and the voltage resistance property will be reliably retained.

In addition, the LLDPE may preferably have a density of at least 0.90 g/cm³, and also, the density is preferably up to 0.94 g/cm³ since the density in excess of 0.94 g/cm³ may invite decrease in the dispersibility of the LLDPE in the polypropylene resin and peeling of the resin by the friction with the metal roll or rubber roll which may result generation of the white powder. Content of the α-olefin in the LLDPE is preferably 0.5 to 10% by mole, and more preferably 2.0 to 8.0% by mole since the density of the LLDPE can be adjusted to the range of at least 0.90 g/cm³ and up to 0.94 g/cm³ by the control of the α-olefin content to the range of 0.5 to 10% by mole.

Furthermore, the LLDPE used in the layer A of the present invention may preferably have a melt flow rate (hereinafter abbreviated as MFR) at 190°C of 0.5 to 10.0 g /10 minutes, and more preferably 1.0 to 5.0 g /10 minutes. The use of the LLDPE having an MFR of 0.5 g /10 minutes or higher suppresses occurrence of inconsistent lamination with other layers in the film formation. On the other hand, handling difficulty in the casting and brittleness due to increase in the degree of crystallization are less likely to occur when the MFR is up to 10.0 g /10 minutes, and use of the LLDPE having an MFR in such range is preferable.

When a low density polyethylene (hereinafter abbreviated as LDPE) is used for the layer A of the present invention, the density is preferably in the range of 0.90 to 0.93 g/cm³. The density of at least 0.90 g/cm³ is preferable in view of reliably providing a good film slipping property as well as favorable handling of the film in the converting process. On the other hand, the density of up to 0.93 g/cm³ facilitates realization of the effect of improving the dispersibility between the polyethylene resin and the polypropylene resin.

When a high density polyethylene (hereinafter abbreviated as HDPE) having a density of 0.94 to 0.97 g/cm³ is used for the layer A of the present invention, the resulting film may suffer from smudge and defects due to the white power formed by the peeling of the HDPE by the friction with the rolls in the converting process despite high strength and curling resistance of the resulting film. In addition, since melting point of the HDPE is higher than LLDPE and LDPE, careful choice of the conditions including use of a higher temperature in the thermal adhesion with the EVA is required, and the adhesion strength with the EVA may become insufficient depending on the condition selected for the thermal adhesion.

As described above, in the layer A of the present invention, the polyethylene resin should be mixed with a polypropylene resin. Such mixing with the polypropylene resin will improve heat resistance and adhesion with the layer B.

In the layer A of the present invention, the polypropylene resin is preferably blended at 50 to 500 parts by weight in relation to 100 parts by weight of the polyethylene resin since the adhesion with the EVA will be reliably realized when the polypropylene resin of less than 500 parts by weight is blended in relation to 100 parts by weight of the polyethylene resin while the blending in excess of 50 parts by weight will result in the improved heat resistance as well as improved adhesion with the layer B.

The term "heat resistance" as used in the present invention means that the sheet can endure the lamination of 130 to 170°C required in the converting process when the sheet is used as a back-protective sheet for a solar cell module. More specifically, it is important that the thickness of all of the layer A / layer B / layer C of the polyolefin resin multi-layer film retains at least 80% of the initial thickness when the resins constituting the back-protective sheet for the solar cell module is deformed by the heat and pressure in the lamination in the production step of the solar cell module having wiring of bus bar and the like assembled in the module. Since the thickness of the back-protective sheet directly contributes for the voltage resistance property, the voltage resistance property can be realized by retaining the initial thickness. A solar cell module having excellent design property will also be produced with the wiring member such as bus bar invisible through the sheet.

Examples of the polypropylene resin include homo-polypropylene, ethylene - propylene random copolymer, and ethylene - propylene block copolymer.

When a copolymer of ethylene and propylene is used, preferable copolymer is the one having an ethylene content of 1 to 15% by mole. When the ethylene content is in excess of 1% by mole, the ethylene - propylene copolymer will be highly dispersible in the LLDPE, the LDPE, or a mixed resin thereof, and the resin will be less likely to be peeled off by the friction with the metal roll or the rubber roll, and generation of the white powder is thereby prevented and the adhesion with the EVA will be improved. On the other hand, when the ethylene content is less than 15% by mole, the thickness of the sheet will not be reduced in the thermal pressing with the EVA, and members like the bus bar will be sufficiently concealed.

The MFR at 230°C of the polypropylene resin is preferably in the range of 1.0 to 15 g /10 minutes. When the MFR is more than 1.0 g /10 minutes, the film width is less likely to be reduced below the extrusion width of the die (neck down) in the film formation step, and stable production of the film is thereby facilitated. When the MFR is less than 15 g /10 minutes, crystallization speed will be reduced and the film will not become brittle.

The polypropylene resin may preferably have a melting point in the range of 140°C to 170°C in view of the heat resistance, and also, in view of slipping property, handling of the film, curling resistance, and thermal adhesion with the EVA. When the melting point is 140°C or higher, the layer A will have an excellent heat resistance, and reduction in the sheet thickness in the thermal adhesion with the EVA in producing the back-protective sheet for a solar cell module will be suppressed, and voltage resistance property will be realized. When the melting point is up to 170°C, excellent adhesion with the EVA will be realized.

The average surface roughness Ra of the layer A of the present invention is preferably in the range of 0.10 to 0.30 µm in view of satisfactory handling function of the film during the converting process.

The layer A of the present invention may have inorganic or organic particles having an average particle diameter of 1 to 5 µm added thereto at an amount of 0.1 to 10% by weight in relation to the resin component of the layer A in order to improve handling convenience and slipping property of the film.

The resin component of the layer A may also have a lubricant comprising an organic compound at an amount of 0.1 to 10% by weight. Exemplary organic compound lubricants include stearic acid amide and calcium stearate.

Next, the layer B of the present invention comprises a polypropylene resin composition containing white fine particles. The polypropylene resin composition as used herein is the composition wherein the polypropylene resin is at least one resin selected from homo-polypropylene and random or block copolymer of ethylene and propylene, or a mixed resin of such resin and polyethylene, wherein the polyethylene content is less than 30% by weight in the entire resin component in view of the heat resistance.

When a copolymer of ethylene and propylene is used for the polypropylene resin, content of the ethylene is preferably up to 15% by mole in view of the heat resistance.

The polypropylene resin may have a MFR at 230°C of 1.0 to 15 g /10 minutes in view of the lamination in the co-extrusion of the layer A with the layer C as described below. When the MFR is more than 1.0 g /10 minutes, the film melt extruded from the die in the film formation step is less likely to experience the neck down, and the film flatness in the transverse direction will not be poor, and stable film formation is enabled. When the MFR is less than 15 g /10 minutes, crystallization speed will be reduced, and the film is less likely to become brittle.

The white fine particles used in the layer B of the present invention is preferably fine particles of an inorganic material such as calcium carbonate, silica, alumina, magnesium hydroxide, zinc oxide, talc, kaolin clay, titanium oxide, or barium sulfate in view of the weatherability. Among these, the most preferred is the titanium oxide particles, and of the crystal types such as rutile type, anatase type, and brookite type, the preferred is rutile type considering the excellent whiteness, weatherability, and light reflection.

When titanium oxide is used in the present invention, the titanium oxide may deteriorate the resin by a photocatalytic action, and therefore, the titanium oxide particles are preferably subjected to a surface covering treatment with a surface covering agent for the purpose of suppressing the photocatalytic action. While the surface covering agent is not limited for its composition, the surface covering agent preferably comprises an inorganic oxide such as silicon oxide, alumina, or zinc oxide. The method used for the surface coverage by the surface covering agent is not particularly limited, and titanium oxide particles having the surface covered by a known method can be used.

A photostabilizer such as a hindered amine photostabilizer may also be added to the resin for the purpose of stabilizing the titanium oxide particles.

The white fine particles used in the present invention may preferably have an average particle diameter of 0.2 to 0.7 µm, and for the purpose of improving the reflectance of the visible light, the average particle diameter is more preferably 0.25 to 0.35 µm.

The white fine particles of the layer B used in the present invention is preferably added at an amount in the range of 5 to 50% by weight of the polypropylene resin although the content may depend on the specific weight of the white fine particles. More preferably, the white fine particles of the layer B are added at an amount in the range of 10 to 30% by weight in relation to the polypropylene resin. When the content is 5% by weight or higher in relation to the polypropylene resin, sufficient whitening and light reflection effects are realized, and the resulting solar cell module will have excellent design property with the wiring member such as bus bar being invisible through the sheet. On the other hand, when the content is less than 50% by weight, the white fine particles are less likely to be aggregated in the film formation, and stable film formation is thereby facilitated.

Next, the layer C of the present invention comprises a polypropylene resin composition, and as in the case of the layer B, the polypropylene resin composition is preferably the one wherein the main component is at least one resin selected from polypropylene resins such as homo-polypropylene and random or block copolymers of ethylene and propylene, and the content of the polyethylene resin is at least 70% by weight in consideration of the heat resistance, and the most preferred is the block copolymer in view of the heat resistance, slipping property, film handling property, scratch resistance, and curling resistance. The polypropylene resin may preferably have a melting point in the range of 150°C to 170°C in views of the heat resistance, slipping property, film handling property, scratch resistance, and curling resistance. When the melting point is 150°C or higher, the resulting sheet will enjoy excellent heat resistance, and the sheet thickness will not be reduced by the temperature and the pressure applied in the adhesion of the back-protective sheet for a solar cell module with the EVA by thermal pressing, and the members such as bus bar will remain invisible. When the resin selected has a melting point of up to 170°C, difference in the degree of crystallization with the layer B will be small and winding property of the film will be improved due to the reduced film curling, and also, adhesion with other substrate will also be improved.

The MFR at 230°C of the polypropylene resin is preferably in the range of 1.0 to 15 g/10 minutes. When the MFR is more than 1.0 g/10 minutes, neck down is less likely to occur, and stable film formation is facilitated. When the MFR is less than 15 g/10 minutes, crystallization speed will be reduced, and the film is less likely to become brittle.

The polyolefin resin multi-layer film in the present invention may preferably have a thickness in the range of 10 to 250 µm although the thickness may vary by the structure of the solar cell employing the polyolefin resin multi-layer film, and the thickness is more preferably in the range of 20 to 200 µm in view of the film production and workability in the lamination with other substrates. The film with the thickness of up to 250 µm is economically favorable, and the handling is also facilitated. More preferably, the polyolefin resin multi-layer film may have a thickness of 50 to 200 µm, and more preferably 130 to 200 µm in order to produce the back-protective sheet for a solar cell module having the heat resistance and the coverage property sufficient to prevent the photovoltaic cell, the interconnector, and bus bar becoming visible by the thinning of the back-protective sheet for a solar cell module by the influence of the wiring member, which is an important object of the present invention

The polyolefin resin multi-layer film of the present invention is constituted from the layer A / layer B / layer C, and the lamination thickness ratio is not particularly limited. However, each of the layer A and the layer C may preferably constitute 5 to 20%, and the layer B may preferably constitute 90 to 60% in relation to 100% of the entire polyolefin resin multi-layer film. By employing the layer A / layer B / layer C constitution, the layer B containing the white fine particles will be sandwiched between the layer A and the layer C, and this avoids the problems such as deposition of the resin degradation products containing a large amount of the particles on the die in the time of the production and contamination of the production process by the falling of the decomposition products, as well as quality problems such as defects in the film.

Next, the method for producing the polyolefin resin multi-layer film of the present invention is described in detail. The film production method of the present invention, however, is not limited to those described below.

The resin used for the layer A may be a resin mixture prepared by mixing 50 to 500 parts by weight of a polypropylene resin with 100 parts by weight of a LLDPE having a melting point in the range of 110°C to 130°C.

The resin used for the layer B may be a resin mixture prepared by mixing 5 to 50% by weight of the rutile type titanium oxide having an average particle diameter of 0.3 µm as the white fine particles and 0.05 to 0.35% by weight of "Sumilizer GP" as the antioxidant with a polypropylene resin having a melting point in the range of 140°C to 170°C.

The resin used for the layer C was a polypropylene resin having a melting point of 150 to 170°C. The thus prepared resins are supplied to each mono-axial melt extruder, and the resins are respectively melted at a temperature in the range of 220 to 280°C. After removing foreign matters and coarse inorganic particles by the filter provided in the polymer pipe, the 3 layers of 3 resin types (layer A / layer B / layer C) are laminated at the multi-manifold type T die or the feed block provided above the T die, and the sheet is ejected from the T die onto a rotating metal roll with the side of the layer C in contact with the metal roll surface to thereby obtain an unstretched film. In this step, the surface temperature of the rotating metal roll is preferably controlled to 20 to 60°C for improving the crystallinity and preventing sticking of the layer C onto the metal roll. In addition, close contact of the melt polymer with the metal roll is preferably facilitated by blowing air from the side opposite to the metal roll side or by using a nip roll.

The UV absorbing layer in the present invention may comprise, for example, a resin composition prepared by blending a UV absorbent in a binder resin such as an acrylic resin, and a resin composition prepared by copolymerizing a UV absorbent and a photostabilizer with the acrylic resin or the like. Use of the UV absorbing layer comprising the resin composition prepared by copolymerizing a UV absorbent and a photostabilizer with the acrylic resin or the like is preferable in view of the adhesion to the substrate plastic film and the weatherability of the UV absorbing layer itself.

Exemplary UV absorbents copolymerized with the acrylic resin include salicylic acid UV absorbents, benzophenone UV absorbents, benzotriazole UV absorbents, cyano acrylate UV absorbents.

Exemplary photostabilizers copolymerized with the acrylic resin include photostabilizers such as hindered amine photostabilizers.

Addition of a white pigment in the UV absorbing layer of the present invention is preferable for improving weatherability of the resin in the UV absorbing layer, and the white pigment is preferably titanium oxide in view of the availability, price, chromogenic performance, and UV resistance.

UV absorbing layer of the present invention may preferably have a thickness of 0.2 to 5 µm, more preferably 1 to 4 µm, and most preferably 1 to 3 µm. When the thickness of the UV absorbing layer is 0.2 µm or more, uniform coating film can be readily formed with no occurrence of phenomena such as repellency or breaking of coating fluid in the coating process, and adhesion to the substrate plastic film, and in particular, UV shielding performance can be fully realized, and use of such thickness is preferable. On the other hand, the UV shielding performance is sufficiently realized at the thickness of the UV absorbing layer of 5 µm or less, and the thickness in excess of 5 µm has the silk of limitation in the coating method and unduly increased production cost.

The UV absorbing layer in the present invention is formed as the outermost layer of the back-protective sheet for a solar cell module film since it has the effect of protecting the resin substrate.

The adhesive used for adhering the plastic film and the polyolefin resin multi-layer film in the present invention is not particularly limited while use of isocyanate crosslinkable adhesives is usual. Among these, use of an adhesive having high hydrolysis resistance is preferable for producing a back-protective sheet for a solar cell module having an excellent,weatherability experiencing reduced long term loss of the adhesive force.

The solvent used in the adhesive of the present invention is preferably a solvent having no active hydrogen such as an ester, a ketone, an aliphatic compound, or an aromatic compound. Exemplary esters include ethyl acetate, propyl acetate, and butyl acetate, and exemplary ketones include methyl ethyl ketone, methyl isobutyl ketone, and cyclohexanone. Exemplary aliphatic compounds include n-heptane, n-hexane, and cyclohexane, and exemplary aromatic compounds toluene and xylene. Among these, the most preferred are ethyl acetate, propyl acetate, and methyl ethyl ketone in view of the solubility and coating applicability.

The adhesive layer may preferably have a thickness of 0.1 to 10 µm, and in view of the cost and adhesiveness, the thickness is more preferably 2 to 6 µm.

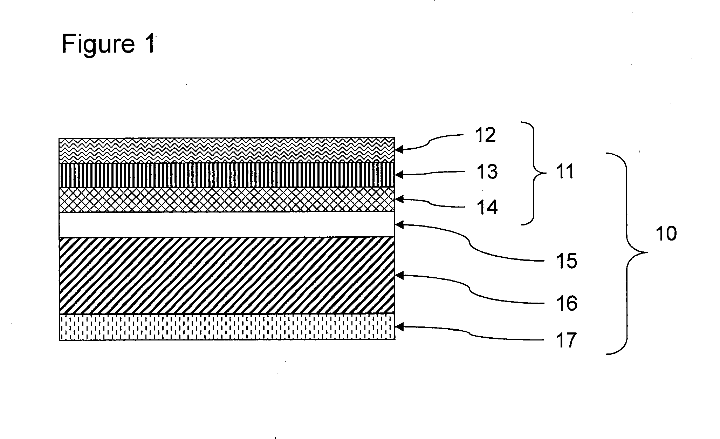

Exemplary methods used for producing the back-protective sheet for a solar cell module of the present invention include lamination of other plastic film or other laminate on the plastic film by dry lamination or other known method wherein an adhesive is coated by using a coating using gravure roll coating, roll coating, reverse coating, kiss coating, or other coating or printing. In this procedure, the plastic film may be subjected to an optional treatment such as corona treatment, plasma treatment, and the like for improving the adhesion property. Also, a UV absorbing layer (17) may be preliminarily formed on the plastic film on the side opposite to the side where the adhesive is formed by dry lamination or other known method wherein an adhesive is coated by using a coating using gravure roll coating, roll coating, reverse coating, kiss coating, or other coating or printing. Next, the surface of the plastic film (16) having the adhesive (15) coated thereon is adhered to the surface of the polyolefin resin multi-layer film (11) on the side of the layer C (14). FIG. 1 is a schematic side cross sectional view of an embodiment of the back-protective sheet for a solar cell module (10).

The adhesion strength between the plastic film and the polyolefin resin multi-layer film is preferably at least 2 N/15 mm. When the adhesion strength between these films is at least 2 N/15 mm, interlayer adhesion strength between the laminated films will be sufficient and interlayer delamination is less likely to occur in the converting process of the solar cell module or accelerated aging test, and the adhesion strength is preferably at least 6 N/15 mm.

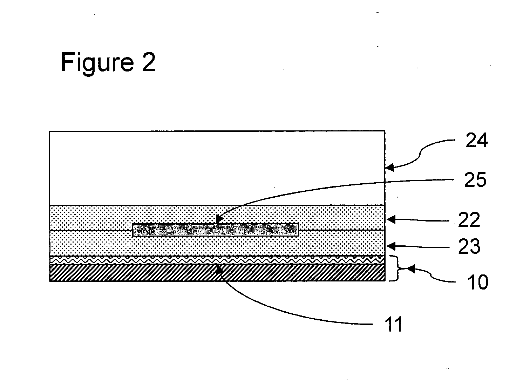

Next, the method for producing a solar cell module by using the back-protective sheet for a solar cell module of the present invention is described. FIG. 2 is a schematic cross-sectional view showing an embodiment of the production of the solar cell module.

The back-protective sheet for a solar cell module preferably has a thickness in the range of 200 to 400 µm. When the thickness is at least 200 µm, high partial discharge voltage as well as sufficient rigidity will be realized, and folding defects in the handling will be markedly reduced. On the other hand, when the thickness is up to 400 µm, length of the sheet wound per roll can be increased while retaining the necessary and sufficient rigidity and voltage resistance property, and accordingly, high productivity will be realized. The thickness is more preferably in the range of 250 to 350 µm.

The back-protective sheet for a solar cell module (10) / the adhesive resin layer 2 (23) / photovoltaic cell provided with wiring (25) / the adhesive resin layer 1 (22) / the front protective sheet for a solar cell module (24) are laminated in this order so that the surface of the back-protective sheet for a solar cell module (10) on the side of the polyolefin resin multi-layer film (11) faced the adhesive resin layer 2 (23), and if desired, other materials may be optionally sandwiched between these layers, and these layers may be integrated and thermally pressed the pressing commonly used in the art such as lamination wherein these layers are integrated by vacuum suction and thermally pressed. A frame is then provided to produce the solar cell module.

The front protective sheet for a solar cell module (24) constituting the solar cell module is preferably provided with physical or chemical strength such as transparency to sun light, electric insulation, weatherability, heat resistance, light resistance, water resistance, moisture prevention, and smudge resistance. Exemplary members used for the front protective sheet include glass plates and films and sheets of polyamide resin (various types of nylon), polyester resin, cyclic polyolefin resin, polystyrene resin, (meth)acryl resin, polycarbonate resin, acetal resin, and other resins.

The adhesive resin layer 1 (22) is preferably provided with weatherability, heat resistance, and transparency. More specifically, the encapsulat layer may be prepared by using, for example, ethylene - vinyl acetate copolymer, ionomer resin, ethylene - acrylic acid copolymer, acid-modified polyolefin resin, polyvinyl butylal resin, silicone resin, epoxy resin, (meth)acryl resin, other resins, or a mixture of two or more such resins.

The photovoltaic cell (25) which is the photovoltaic element constituting the solar cell module may be a known element. Exemplary such elements include crystalline silicon photovoltaic cells such as monocrystalline silicon photovoltaic cell and polycrystalline silicon photovoltaic cell; amorphous silicon photovoltaic cells such as single junction or tandem structure elements; Group III-V semiconductor photovoltaic cells such as gallium arsenide (GaAs) and indium phosphide (InP); Groups II-VI compound semiconductor photovoltaic cells such as cadmium telluride (CdTe) and copper indium selenide (CuInSe₂); organic photovoltaic cells; and other elements. Other exemplary elements include thin film polycrystalline silicon photovoltaic cell, thin film microcrystalline silicon photovoltaic cell, and hybrid of thin film crystalline silicon photovoltaic cell and amorphous silicon photovoltaic cell.

The adhesive resin layer 2 (23) disposed under the photovoltaic element constituting the solar cell module may be the one comprising the same material as the adhesive resin layer 1 (22). The adhesive resin layer 2 (23) is preferably capable of adhering to the back-protective sheet. These adhesive resin layers may have thermoplasticity in view of fulfilling the function of retaining the slipping property of the rear surface of the photovoltaic cell, and in view of the protection of the photovoltaic cell as the photovoltaic element, the adhesive resin layers may preferably have high scratch resistance, impact absorption ability, and the like.

The frame of the solar cell module is preferably prepared from an aluminum frame member.

### Examples

Next, the present invention is described in further detail by referring to Examples. The properties were measured and evaluated by the procedures as described below.

### [Method for measuring the density]

The density was measured according to (ASTM) D1505.

### [Method for measuring MFR]

The melt flow rate (MFR) of the LLDPE and the LDPE was evaluated according to ASTM D1238 at 190°C with the load of 2.16 kg, and the MFR of the homo-polypropylene, the ethylene - propylene block copolymer, and the ethylene - propylene random copolymer was measured at 230°C with the load of 2.16 kg.

### [Measurement of the melting point]

The melting point of the resin used was measured using a differential scanning calorimeter (DSC-60 manufactured by Shimadzu Corporation) by raising the temperature from 20°C to 300°C at a rate of 10°C/minute, and the peak temperature with the highest melt peak was used as a melting point.

### [Reflectance]

The surface on the side of the polyolefin resin multi-layer film of the solar cell module back-protective sheet was evaluated three times for the absolute reflectance at 560 nm by using a spectrophotometer (U-3410 manufactured by Hitachi, Ltd.) with ϕ60 integrating sphere (130-0632 manufactured by Hitachi, Ltd.) and 10 degrees tilt spacer. The average was calculated for use as the reflectance.

### [Heat resistance test: visibility of the interconnector due to the transparency]

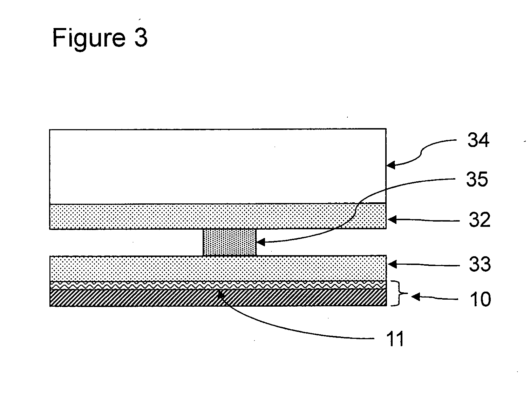

As shown in FIG. 3, the back-protective sheet for a solar cell module (10) / the EVA sheet 2 (33) (PV-45FR000 having a thickness of 450 µm manufactured by by SANVIC Inc.) / the interconnector (35) (2 mm (width) x 0.6 mm (thickness)) / the EVA sheet 1 (32) (thickness, 450 µm) / the glass plate (34) were laminated in this order so that the surface of the back-protective sheet for a solar cell module (10) on the side of the polyolefin resin multi-layer film (11) faced the EVA sheet 2 (33), and the laminate was placed in a solar cell module laminator (LM-50X50-S) manufactured by NPC. The thermal pressing was conducted under the conditions of a vacuum time of 5 minutes, a control time of 1 minute, a pressing time of 9 minutes, and a temperature of 142°C. After the pressing, the laminate was cooled to the room temperature to thereby prepare a pseudo-module.

10 modules were prepared by the procedure as described above, and the module was visually examined from the side of the back-protective sheet for a solar cell module. The transparency was evaluated by the following criteria and the module with the evaluation of "4" or higher was regarded "pass".
5: the interconnector is visible due to the transparency in none of 10 sheets;
4: the interconnector is slightly visible due to the transparency in 1 of 10 sheets and not in the remaining sheets;
3: the interconnector is slightly visible due to the transparency in 2 or more sheets of 10 sheets but the interconnector was not clearly visible;
2: interconnector is clearly visible due to the transparency in 1 of 10 sheets; and
1: interconnector is clearly visible due to the transparency in 2 or more sheets of 10 sheets.

### [Heat resistance test: observing the thickness of the polyolefin resin multi-layer film]

The pseudo- module after the heat resistance test was cut with a cutter, and the cross section at the interconnector part of the back-protective sheet for a solar cell module was observed by a polarization microscope (ECLIPSE E400POL manufactured by Nikon Corporation) at a magnification of 200. The change in the thickness of the entire polyolefin resin multi-layer film was evaluated by the following criteria, and the module with the evaluation of "+" or higher was regarded "pass".
++: change in the thickness is less than -5%,
+ : change in the thickness is at least -5% and less than -20%, and
- : change in the thickness is at least -20%.

### [Measurement of the adhesion strength between the back-protective sheet for a solar cell module and the EVA]

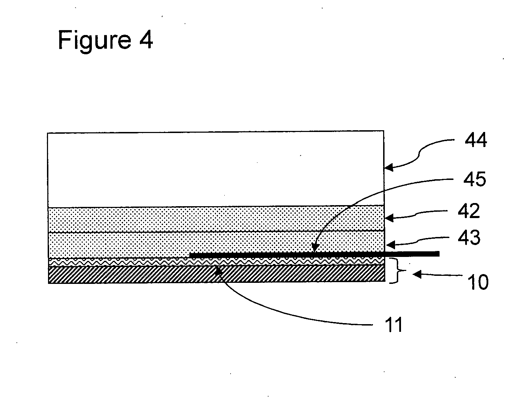

As shown in FIG. 4, the back-protective sheet for a solar cell module (10) / the release film (45) / the EVA sheet 2 (43) / the EVA sheet 1 (42) / the glass plate (44) were laminated in this order so that the surface of the back-protective sheet for a solar cell module (10) on the side of the polyolefin resin multi-layer film (11) faced the EVA sheet 2 (43), and the laminate was placed in a solar cell module laminator (LM-50 x 50-S) manufactured by NPC. The thermal pressing was conducted under the conditions of a vacuum time of 5 minutes, a control time of 1 minute, a pressing time of 9 minutes, and a temperature of 142°C. After the pressing, the laminate was cooled to room temperature to thereby prepare a pseudo-module. The adhesion strength between the back-protective sheet for a solar cell module and the EVA was measured by using the pseudo-module.

On the side of the back-protective sheet for the solar cell module, the peeling was conducted between the back-protective sheet for the solar cell module and the EVA layer at a width of 10 mm at room temperature condition by using Tensilon PTM-50 manufactured by Orientec, and at a peel angle of 180° and a peel speed of 100 mm/min to evaluate the adhesion strength by the following criteria. The peel strength of "+" or higher was evaluated as acceptable.
++: peel strength is at least 50 N/10 mm,
+ : peel strength is less than 50 N/10 mm and at least 40 N/10 mm,
-: peel strength is less than 40 N/10 mm and at least 20 N/10 mm, and
--: peel strength is less than 20 N/10 mm.

Next, Examples of the present invention and the Comparative Examples are described.

### [Evaluation of the UV resistance]

24 hour UV irradiation was conducted by using Eye Super UV tester SUV-W151 manufactured by Iwasaki Electric Co.,Ltd. in an atmosphere at a temperature of 63°C and a relative humidity of 30% with UV irradiation strength of 160mW/cm² (cumulative UV irradiation, 206 kWh/m²). The b* value in the colorimetric system was measured before and after the UV irradiation. The result was evaluated pass ("++") when the difference in the b* value was less than 6, pass ("+") when the difference was less than 30, and fail ("-") when the difference was at least 30.

### [Method for producing titanium oxide master batch A]

40% by weight of a homo-polypropylene having a melting point of 162°C and a density of 0.900 g/cm³ and 60% by weight of a rutile type titanium oxide having an average particle diameter of 200 nm surface treated with an inorganic oxide containing at least one member selected from silicon, aluminum, zinc, and the like as its main component (FTR-700 manufactured by Sakai Chemical Industry Co.,Ltd.) were melt kneaded in a biaxial extruder at 240°C, and extrudate was cut into strands to prepare the titanium oxide master batch A.

### [Method for producing titanium oxide master batch B]

40% by weight of a LLDPE having a melting point of 122°C, a density of 0.922 g/cm³, and a MFR of 7 g/10 minutes and 60% by weight of a rutile type titanium oxide having an average particle diameter of 200 nm surface treated with an inorganic oxide containing at least one member selected from silicon, aluminum, zinc, zirconium, and the like as its main component (FTR-700 manufactured by Sakai Chemical Industry Co.,Ltd.) were melt kneaded in a biaxial extruder at 210°C, and extrudate was cut into strands to prepare the titanium oxide master batch B.

### (Example 1)

The resin used for the layer A was the resin prepared by mixing 20 parts by weight of a LDPE having a melting point of 112°C, a density of 0.912 g/cm , and a MFR of 4.0 g /10 minutes with 80 parts by weight of a LLDPE having a melting point of 127°C, a density of 0.940 g/cm³, and a MFR of 5.0 g /10 minutes (the total of the polyethylene resins, 100 parts by weight), and 100 parts by weight of an ethylene - propylene random copolymer (hereinafter abbreviated as EPC) having a melting point of 150°C, a density of 0.900 g/cm³, a MFR of 7 g/10 minutes, and an ethylene content of 4% by mole as the polypropylene resin.

The resin used for the layer B was a resin mixture prepared by mixing 30 parts by weight of titanium oxide master batch A with 100 parts by weight of a homo-polypropylene (hereinafter abbreviated as H-PP) having a melting point of 160°C, a density of 0.900 g/cm³, and a MFR of 7 g/10 minutes. Amount of the titanium oxide added as the coloring agent was 13.8% by weight.

The resin used for the layer C was an ethylene - propylene block copolymer (hereinafter abbreviated as B-PP) having a melting point of 160°C, a density of 0.900 g/cm³, a MFR of 4.0 g /10 minutes, and an ethylene content of 7% by mole.

The thus prepared resins of the layer A, layer B, and layer C were respectively supplied to a monoaxial melt extruder, and each resin was melted at 260°C. The thus melted resins were guided to a multi-manifold T die of of layer A / layer B / layer C type, and extruded onto a casting drum kept at 30°C. The cast film was cooled and solidified by blowing cool air at 25°C from the side opposite to the drum to thereby produce a polyolefin resin multi-layer film having a constitutional thickness ratio (layer A/layer B/layer C) of 10%/80%/10%, and a film thickness of 150 µm.

The surface of the polyolefin resin multi-layer film on the layer C side was treated by corona discharge treatment until the wetting tension was 40 mN/m, and the film was wound up.

White fine particles, a plasticizer, and the solvent were added at once to a coating composition "HALS hybrid " polymer (Registered Trademark) BK1 (solid content, 40% by weight, acrylic resin) comprising an acryl polyol resin having a UV absorbent and photostabilizer (HALS) crosslinked thereto produced by Nippon Shokubai Co., Ltd., and the mixture was dispersed in a bead mill to prepare a coating composition having a solid content of 50% by weight for the formation of a resin layer.

Next, "Desmodur (Registered Trademark)" N3300 (solid concentration, 100% by weight) manufactured by Sumika Bayer Urethane Co., Ltd. (a isocyanurate-type hexamethylene diisocyanate) was added to the coating composition for the formation of the resin layer which had been prepared by the method as described above at a preliminarily calculated amount so that the weight ratio of the main component to the Desmodule would be 33/8. This mixture was then diluted by adding n-propyl acetate (a diluent) at a preliminarily calculated amount required for preparing a coating composition having a solid concentration (resin solid concentration) of 20% by weight, and the dilution was stirred for 15 minutes to prepare a coating composition for forming the UV absorbing layer having a solid concentration (resin solid concentration) of 20% by weight.

The white fine particles used for the preparation as described above were titanium oxide particles (JR-709 manufactured by Tayca Corporation), and the plasticizer was an epoxy plasticizer ("Epocizer" W-121) manufactured by DIC Corporation.

The plastic film used was a hydrolysis-resistant biaxially oriented PET film ("Lumilar (Registered Trademark)" X10S (125 µm) manufactured by Toray Industries, Inc.). The coating composition for forming the UV absorbing layer as described above was coated on one surface of the substrate film by using a dry laminator (dry laminator equipped with a mono-color printer, OG/DL-130TA-AF manufactured by Okazaki Machine Industry Co., Ltd.), and coating was dried at 150°C for 30 seconds to thereby formed an UV absorbing layer having a dry coating weight of 4.0 g /m².

Next, an adhesive crosslinked with an isocyanate (LX-903/KL-75=8/1 manufactured by Dainippon Ink and Chemicals, Incorporated) was coated to a solid coating thickness of 5 µm with the dry laminator as described above on the surface not coated with the "Luminar (Registered Trademark)" X10S as described above, and the coating was dried. The layer C side of the polyolefin resin multi-layer film as described above was then laminated at a nip pressure of 60 N/cm.

The back-protective sheet for the solar cell module had a thickness of 285 µm.

The thus laminated film was aged at a temperature 40°C for 72 hours to promote the curing of the adhesive layer to thereby prepare the back-protective sheet for a solar cell module of the present invention. The results of the evaluation are shown in Table 1.

### (Example 2)

The polyethylene resin used for the layer A was the LDPE used in Example 1, and this LDPE was used alone. The polypropylene resin used was 150 parts by weight of the EPC used in Example 1, and it was used in relation to 100 parts by weight of the LDPE.

The resin used for the layer B was a resin prepared by mixing 100 parts by weight of an EPC having a melting point of 150°C, a density of 0.900 g/cm , a MFR of 7 g/10 minutes, and an ethylene content of 4% by mole, and 20 parts by weight of titanium oxide master batch A with 100 parts by weight of a B-PP having a melting point of 160°C, a density of 0.900 g/cm , a MFR of 4 g/10 minutes, and an ethylene content of 7% by mole. Content of the titanium oxide which was the white fine particles was 5.5% by weight.

The resin used for the layer C was a resin prepared by mixing 100 parts by weight of a H-PP having a melting point of 162°C, a density of 0.900 g/cm³, and a MFR of 7 g/10 minutes with 100 parts by weight of the B-PP used in Example 1.

The back-protective sheet for a solar cell module was produced by repeating the procedure of Example 1 except that the resins prepared as described above were used for each of the layers A, B, and C. The results of the evaluation are shown in Table 1.

Reduction in the film thickness in the heat resistance test was at an acceptable level. While the interconnector had an inherent risk of being visible by the transparency due to the low titanium oxide content, the interconnector was at a practically acceptable level.

### (Example 3)

The polyethylene resin used for the layer A was a resin prepared by mixing 200 parts by weight of a B-PP having a melting point of 160°C, a density of 0.900 g/cm³, a MFR of 4 g/10 minutes, and an ethylene content of 7% by mole for the polypropylene resin with 100 parts by weight of the LLDPE used in Example 1.

The resin used for the layer B was a resin prepared by mixing 300 parts by weight of titanium oxide master batch A with 100 parts by weight of the EPC used in Example 2. Content of titanium oxide which was the white fine particles was 45.0% by weight.

The resin used for the layer C was a resin prepared by mixing 100 parts by weight of an EPC having a melting point of 150°C, a density of 0.900 g/cm³, a MFR of 7 g/10 minutes, and an ethylene content of 4% by mole with 100 parts by weight of the H-PP used in Example 2.

The thus prepared resins of the layer A, layer B, and layer C were respectively supplied to a monoaxial melt extruder, and each resin was melted at 260°C. The thus melted resins were guided to a multi-manifold T die of of layer A / layer B / layer C type, and extruded onto a casting drum kept at 30°C. The cast film was cooled and solidified by blowing cool air at 25°C from the side opposite to the drum to thereby produce a polyolefin resin multi-layer film having a constitutional thickness ratio (layer A/layer B/layer C) of 10%/70%/20%, and a film thickness of 150 µm.

A back-protective sheet for a solar cell module was prepared by repeating the procedure of Example 1 except for the use of the thus prepared polyolefin resin multi-layer film. The results of the evaluation are shown in Table 1.

### (Example 4)

The resins used for the layer A and the layer C were the same as those of Example 1.

The procedure of Example 2 was repeated except that 40 parts by weight of a LDPE having a melting point of 112°C, a density of 0.912 g/cm³, and a MFR of 4.0 g /10 minutes was used instead of the B-PP used in Example 2 for the resin of the layer B. Content of titanium oxide which was the white fine particles was 7.5% by weight, and the polyethylene content was 27% by weight of the entire resin component.

The back-protective sheet for a solar cell module was produced by repeating the procedure of Example 1 except that the resins prepared as described above were used for each of the layers A, B, and C. The results of the evaluation are shown in Table 1.

### (Example 5)

The resins used were the same as those of Example 1 except that the EPC used in Example 1 for the layer A was used at an amount of 60 parts by weight.

The back-protective sheet for a solar cell module was produced by repeating the procedure of Example 1 except for the use of the polyolefin resin multi-layer film having a thickness of 100 µm prepared by using each of the resins for the layers A, B, and C prepared as described above. The results of the evaluation are shown in Table 1.

The back-protective sheet for a solar cell module had a thickness of 235 µm. 0120]

### (Example 6)

The resins used were the same as those of Example 1 except that the EPC used in Example 1 for the layer A was used at an amount of 400 parts by weight.

The back-protective sheet for a solar cell module was produced by repeating the procedure of Example 1 except that the polyolefin resin multi-layer film prepared by using each of the thus prepared resins for the layers A, B, and C was laminated with a biaxially oriented PET film having the coating composition for the formation of the UV absorbing layer ("Lumilar (Registered Trademark)" S10 (125 µm) manufactured by Toray Industries, Inc.) on the non-coating side. The results of the evaluation are shown in Table 1.

Some yellowing was found in the evaluation of the UV resistance. The yellowing, however, was practically acceptable level.

### (Example 7)

The resins used were the same as those of Example 1 except that the EPC used in Example 1 for the layer A was used at an amount of 600 parts by weight.

The back-protective sheet for a solar cell module was produced by repeating the procedure of Example 1 except that the resins prepared as described above were used for each of the layers A, B, and C. The results of the evaluation are shown in Table 1.

Adhesion with the EVA was somewhat lower due to the high polypropylene resin content of the layer A. The adhesion, however, was at a practically acceptable level.

### (Example 8)

The resins used were the same as those of Example 1 except that the resin used for the polyethylene resin of the layer A was the resin prepared by mixing 100 parts by weight of the EPC the same as the one used in Example 1 as the polypropylene resin with 100 parts by weight of a HDPE having a melting point of 134°C and a density of 0.952 g/cm³.

The back-protective sheet for a solar cell module was produced by repeating the procedure of Example 1 except that the resins prepared as described above were used for each of the layers A, B, and C. The results of the evaluation are shown in Table 1.

Adhesion strength with the EVA was somewhat lower due to the high melting point of the HDPE of the layer A. The adhesion, however, was at a practically acceptable level.

### (Example 9)

The resin used for the layer B was the same as the one used in Example 4 except that the EPC used in Example 4 was used at 60 parts by weight, the LDPE used in Example 4 was used at 40 parts by weight, and the titanium oxide master batch A was used at 20 parts by weight. The polyethylene concentration in the layer B was 37% by weight, and the polyethylene concentration was relatively high.

The back-protective sheet for a solar cell module was produced by repeating the procedure of Example 1 except that the resins prepared as described above were used for each of the layers A, B, and C. The results of the evaluation are shown in Table 1.

The sheet exhibited some thinning and transparency of the layer B in the heat resistance test due to the high polyethylene concentration of the layer B. The film thickness and the transparency were at a practically acceptable level.

### (Example 10)

The back-protective sheet for a solar cell module was prepared by repeating the procedure of Example 1 except that PEN film "Teonex" Q51 (125 µm) manufactured by Teijin DuPont Films Japan Limited was used for the plastic film. The results of the evaluation are shown in Table 2.

### (Example 11)

The plastic film used was a fluororesin film (easy adhesion FEP film "Toyofluon (Registered Trademark)" FL (100 µm) manufactured by Toray Advanced Film Co., Ltd.). A UV absorbing layer was formed on one surface of the fluororesin film as in the case of Example 1, and the film was further laminated with a polyolefin resin multi-layer film to thereby prepare the back-protective sheet for a solar cell module. The results of the evaluation are shown in Table 2.

### (Example 12)

The plastic film used was a hydrolysis-resistant biaxially oriented PET film ("Lumilar (Registered Trademark)" X10 (125 µm) manufactured by Toray Industries, Inc.) adhered with a fluororesin film (easy adhesion ETFE film "Toyofluon (Registered Trademark)" EL (100 µm) manufactured by Toray Advanced Film Co., Ltd.), and a UV absorbing layer was laminated on the ETFE side. The laminate was further adhered with a polyolefin multi-layer laminate film as in the case of Example 1 to prepare the back-protective sheet for a solar cell module. The results of the evaluation are shown in Table 2.

### (Example 13)

A polyolefin resin multi-layer film having a thickness of 50 µm was prepared by using the polyolefin starting materials of the layer A / layer B / layer C the same as those of Example 1, increasing the content of the titanium oxide master batch A of the layer B to 50 parts by weight, and reducing the amount of the extrusion. Amount of the titanium oxide added to the layer B was 20.0% by weight. The plastic film used was a hydrolysis-resistant biaxially oriented PET film ("Lumilar (Registered Trademark)" X10 manufactured by Toray Industries, Inc. having a thickness of 250 µm, and this film was laminated with the polyolefin resin multi-layer film having a thickness of 50 µm to prepare the back-protective sheet for a solar cell module. The results of the evaluation are shown in Table 2.

The back-protective sheet for a solar cell module had a thickness of 310 µm.

Transparency was found since the polyolefin resin multi-layer film had a thickness as thin as 50 µm. However, the transparency was at a practically acceptable level. The back-protective sheet for a solar cell module had excellent flame retardancy as measured by UL 746A since the hydrolysis-resistant biaxially oriented PET film had a sufficient thickness of 250 µm.

### (Example 14)

A polyolefin resin multi-layer film having a thickness of 125 µm was prepared by using the polyolefin starting materials of the layer A / layer B / layer C the same as those of Example 1, and reducing the amount of the extrusion. The plastic film used was a hydrolysis-resistant biaxially oriented PET film ("Lumilar (Registered Trademark)" X10 manufactured by Toray Industries, Inc. having a thickness of 125 µm, and this film was laminated with the polyolefin resin multi-layer film having the thickness of 125 µm to prepare the back-protective sheet for a solar cell module. The results of the evaluation are shown in Table 2.

The back-protective sheet for a solar cell module thickness had a thickness of 260 µm. Since the olefin resin multilayer film had a rather thin thickness of 125 µm, the sheet exhibited some transparency, but the transparency was at an acceptable level.

### (Example 15)

The back-protective sheet for a solar cell module was prepared by repeating the procedure of Example 1 except that a hydrolysis-resistant biaxially oriented PET film ("Lumilar (Registered Trademark)" X10 manufactured by Toray Industries, Inc.) having a thickness of 100 µm was used for the plastic film. The results of the evaluation are shown in Table 2.

The back-protective sheet for a solar cell module had a thickness of 260 µm.

### (Example 16)

A polyolefin resin multi-layer film having a thickness of 175 µm was prepared by repeating the procedure of Example 14 by increasing the amount of the extrusion. The plastic film used was a hydrolysis-resistant biaxially oriented PET film ("Lumilar (Registered Trademark)" X10 manufactured by Toray Industries, Inc. having a thickness of 75 µm, and this film was laminated with the polyolefin resin multi-layer film having the thickness of 175 µm to prepare the back-protective sheet for a solar cell module. The results of the evaluation are shown in Table 2.

The back-protective sheet for a solar cell module had a thickness of 260 µm.

### (Comparative Example 1)

A back-protective sheet for a solar cell module was prepared by repeating the procedure of Example 1 except that the UV absorbing layer was not laminated on the plastic film (the hydrolysis-resistant biaxially oriented PET film ("Lumilar (Registered Trademark)" X10S (125 µm) manufactured by Toray Industries, Inc.), and the polyolefin resin multi-layer film was lamitated as in the case of Example 1. The results of the evaluation are shown in FIG. 2.

In the evaluation of the UV resistance, difference in the b* value was large, and the sheet was not practically acceptable.

The back-protective sheet for a solar cell module thickness had a thickness of 280 µm.

### (Comparative Example 2)

The resins used for the layer A and the layer C were the same as those of Example 1.

The resin used for the layer B was a resin prepared by mixing 30 parts by weight of titanium oxide master batch B with 100 parts by weight of a LDPE having a melting point of 112°C, a density of 0.912 g/cm³, and a MFR of 4.0 g /10 minutes. Content of titanium oxide which was the white fine particles was 13.8% by weight, and the polyethylene content was 100% by weight of the entire resin component.

The back-protective sheet for a solar cell module was produced by repeating the procedure of Example 1 except that the resins prepared as described above were used for each of the layers A, B, and C. The results of the evaluation are shown in Table 2.

In the heat resistance test, the interconnector was visible due to the transparency in 5 pseudo-modules. The thickness decreased by 50% or more in the part of the polyolefin resin multi-layer film where the interconnector exhibited the transparency.

### (Comparative Example 3)

The procedure of Example 1 was repeated including the resins used for the layer B and the layer C except that the LLDPE used in Example 1 was solely used for the resin of the layer A to thereby produce the back-protective sheet for a solar cell module. The results of the evaluation are shown in Table 2.

While the interconnector did not become visible due to the transparency in the heat resistance test, decrease in the thickness of the polyolefin resin multi-layer film thickness was 20% or more.

### (Comparative Example 4)

The resins used for the layer A and the layer B were the same as those of Example 1.

An LLDPE having a melting point of 127°C, a density of 0.940 g/cm³, a MFR of 5.0 g /10 minutes, and an ethylene content of 5% by mole was solely used for the resin of the layer C.

The back-protective sheet for a solar cell module was produced by repeating the procedure of Example 1 except that the resins prepared as described above were used for each of the layers A, B, and C. The results of the evaluation are shown in Table 2.

While the interconnector was not visible due to the transparency in the heat resistance test, decrease in the thickness of the polyolefin resin multi-layer film thickness was 20% or more.

### (Comparative Example 5)

The procedure of Example 1 was repeated including the resins used for the layer B and the layer C except that the EPC used in Example 1 was solely used for the resin of the layer A to thereby produce the back-protective sheet for a solar cell module. The results of the evaluation are shown in Table 2.

The sheet was insufficient in the adhesion with the EVA.

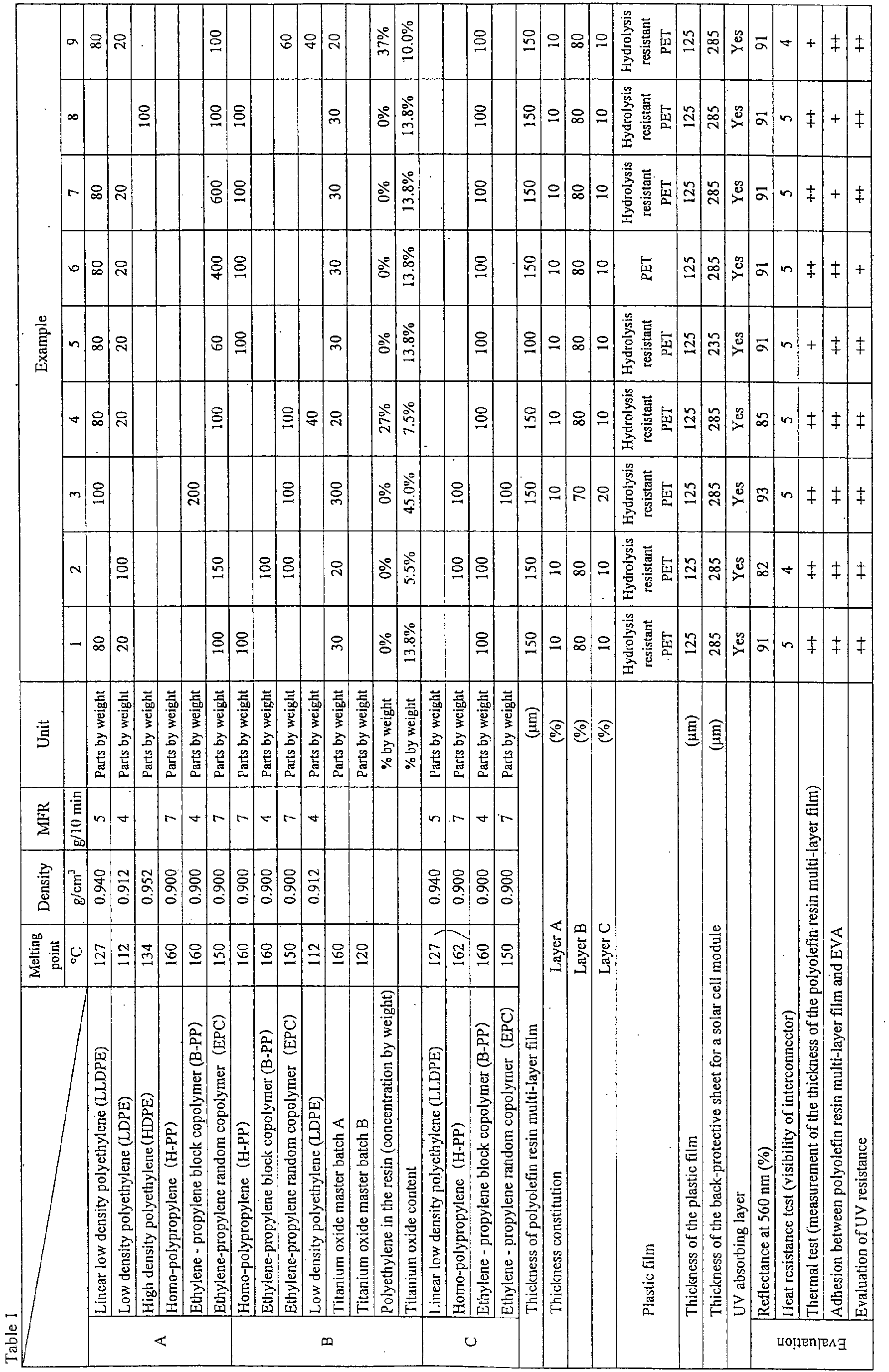

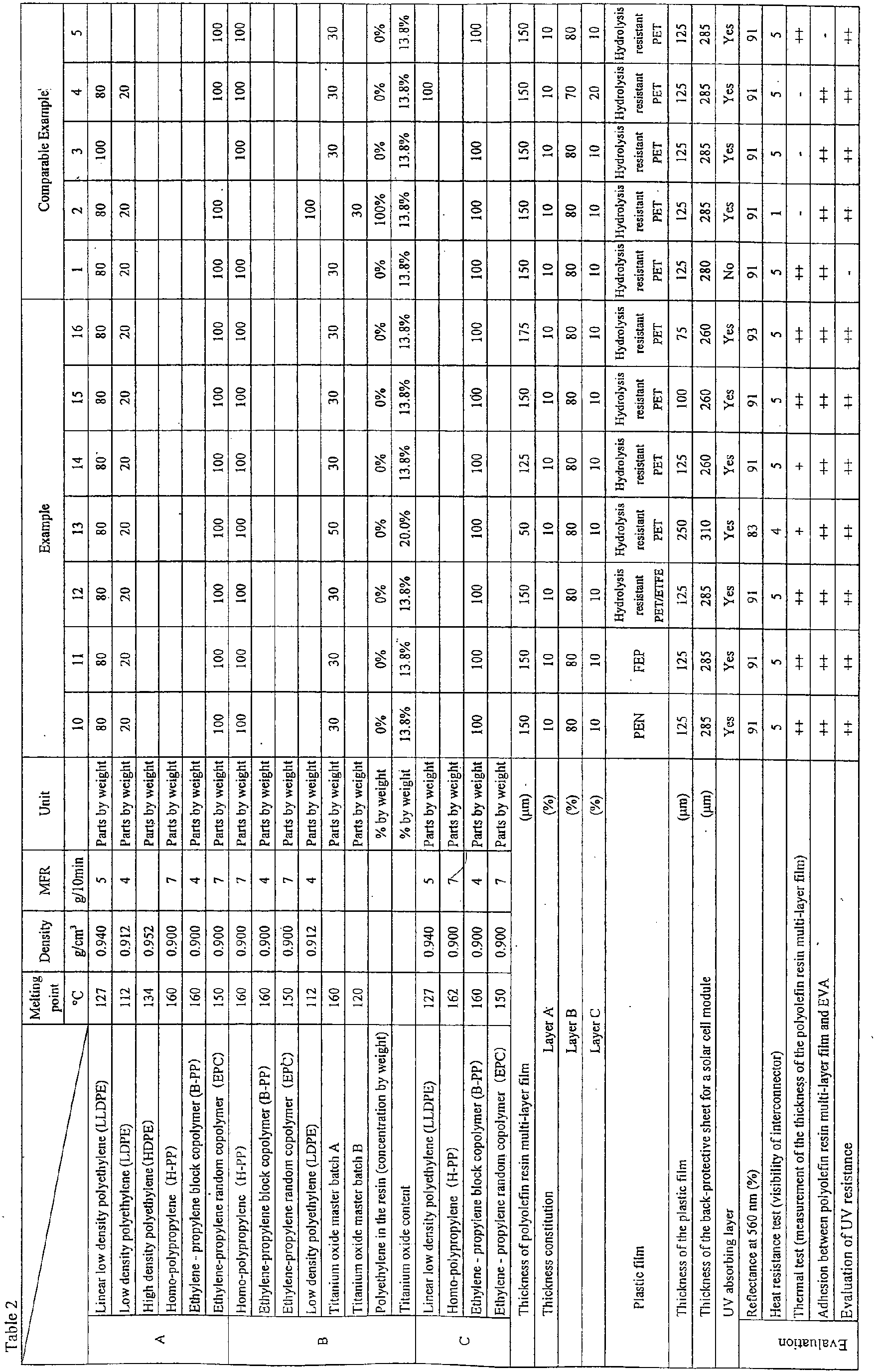

### Explanation of numerals

10: back-protective sheet for a solar cell module
11: polyolefin resin multi-layer film
12: layer A of the polyolefin resin multi-layer film
13: layer B of the polyolefin resin multi-layer film
14: layer C of the polyolefin resin multi-layer film
15: adhesive layer
16: plastic film
17: UV absorbing layer
22: adhesive resin layer 1
23: adhesive resin layer 2
24: front protective sheet for a solar cell module
25: photovoltaic cell
32, 42: EVA sheet 1
33, 43: EVA sheet 2
35: interconnector
34, 44: glass plate
45: release film

## Claims

1. A back-protective sheet for a solar cell module comprising a polyolefin resin multi-layer film having a layer A / layer B / layer C three layer constitution, a plastic film, and a UV absorbing layer disposed in this order; wherein the layer A comprises a resin composition prepared by mixing a polyethylene resin and a polypropylene resin, the layer B comprises a polypropylene resin composition containing white particles, and the layer C comprises a polypropylene resin composition.

2. A back-protective sheet for a solar cell module according to claim 1 wherein the plastic film comprises at least one of polyethylene terephthalate film, hydrolysis resistant polyethylene terephthalate film, and polyethylene naphthalate film.

3. A back-protective sheet for a solar cell module according to claim 1 wherein the plastic film comprises a fluororesin film.

4. A back-protective sheet for a solar cell module according to claim 2 or 3 wherein the plastic film comprises a laminate of a polyethylene terephthalate film or a hydrolysis resistant polyethylene terephthalate film and a fluororesin film, and the UV absorbing layer is provided on the side of the fluororesin film.

5. A back-protective sheet for a solar cell module according to claim 1 wherein the back-protective sheet for a solar cell module has a thickness of 250 to 350 µm, and the polyolefin resin multi-layer film has a thickness of 130 to 200 µm.

6. A back-protective sheet for a solar cell module according to claim 1 wherein the back-protective sheet for a solar cell module has a thickness of 250 to 350 µm, and the plastic film has a thickness of 200 to 250 µm.

7. A solar cell module prepared by using the back-protective sheet for a solar cell module according to any one of claims 1 to 6.
